# EUROPEAN PATENT SPECIFICATION

(11) **EP 4 118 689 B1**
(45) Date of publication and mention of the grant of the patent: **16.09.2026**
(21) Application number: 21766818.5
(22) Date of filing: 10.03.2021
(51) Int. Cl.: F21S 41/141, F21S 41/153, F21S 41/19, H05K 1/02, H05K 1/189, H10H 29/01, H10H 29/03, H10H 29/24, H10H 29/85, H05K 3/34

(54) **LED LIGHTING CIRCUIT AND METHOD OF MANUFACTURING AN LED LIGHTING CIRCUIT**
LED-BELEUCHTUNGSSCHALTUNG UND VERFAHREN ZUR HERSTELLUNG EINER LED-BELEUCHTUNGSSCHALTUNG
CIRCUIT D'ÉCLAIRAGE À DEL ET PROCÉDÉ DE FABRICATION D'UN CIRCUIT D'ÉCLAIRAGE À DEL

(30) Priority: 10.03.2020 US 202016814024; 09.04.2020 EP 20169027
(43) Date of publication of application: 18.01.2023
(73) Proprietor: Lumileds LLC, San Jose, CA 95131 (US)
(72) Inventor: DECKERS, Michael, 52068 Aachen (DE); HIN, Tze Yang, Cupertino, CA 95014 (US); BONNE, Ronald, San Jose, California 95131 (US)
(74) Representative: dompatent
(86) International application number: PCT/US2021/021702
(87) International publication number: WO 2021/183644

(56) References cited:
- WO-A1-2018/172152
- WO-A1-2019/168763
- WO-A1-2019/168763
- JP-A- 2007 129 188
- JP-A- 2011 113 989
- KR-A- 20130 036 650
- US-A1- 2003 201 462
- US-A1- 2013 193 463
- US-A1- 2015 054 406
- US-A1- 2015 054 406
- US-A1- 2019 075 656

## Description

### FIELD OF INVENTION

The disclosure describes an LED lighting circuit and a method of manufacturing an LED lighting circuit

### BACKGROUND

High-lumen light-emitting diode (LED) arrays may be used in lighting applications, such as automotive front lighting applications. For example, an adaptive drive beam system can be realized using an LED array.
WO 2019/168763A1 discloses a display integration scheme in which an array of pixel driver chips are embedded front side up in an insulator layer. A front side redistribution layer (RDL) spans across and is in electrical connection with the front sides of the array of pixel driver chips, and an array of light emitting diodes is bonded to the front side RDL.
JP 2007 129188 A discloses a semiconductor light-emitting device with enhanced heat dissipation and heat resistance, comprising chip LEDs on a silicon sub-mount element by which an insulating oxide layer was formed on the surface, and a required wiring pattern was formed on said oxide layer. A tape-shaped flexible wiring board is mounted on the semiconductor light-emitting device and electrically connected to the required wiring pattern.
US 2013/193 463 A1 discloses an LED-based lighting assembly including a heat sink having at least one pedestal with an upwardly facing, upper planar surface that is raised in a vertical direction relative to an upwardly facing, lower planar surface of the heat sink. A PCB forms an aperture corresponding to the pedestal, includes electrical conductors on an upper surface thereof, and is attached to the lower planar surface. The upper planar surface extends into the aperture, and one or more LED chips attach directly to the upper planar surface and connect to the conductors such that light emits upwardly.
US 2003/201462 discloses an integrated circuit/optoelectronic packaging system which comprises OE and IC components including a transparent insulating substrate having electrical circuitry in a thin silicon layer formed on its top side that is positioned between an optical fiber and an optoelectronic device such that an optical path is described between the optoelectronic device and the optical fiber core through the transparent insulating substrate. Arrays of fibers may be coupled to arrays of optoelectronic devices through a single transparent substrate. The optoelectronic devices are mounted on the transparent insulating substrate in a precise positional relationship to guide holes in the substrate. The optical fibers are fixed in an optical fiber connector and are held in a positional relationship to guide holes in the connector. Alignment is accomplished with complementary guide pins that pass-through guide holes in the fiber optic connector and in the transparent substrate.

### SUMMARY

According to the present invention a method of manufacturing an LED lighting circuit according to claim 1 is provided. Further, according to the present invention an LED lighting circuit according to claim 7 is provided.

The LED lighting circuit comprises an augmented LED array assembly which includes a hybridized device and a flexible PCB. The hybridized device includes a micro-LED array mounted on a driver IC. The driver IC includes driver IC contact pads on a top surface of the driver IC. The flexible PCB has a bottom surface, first contact pads on the bottom surface, second contact pads on the bottom surface, and contact bridges. Each of the contact bridges extends from one of the first contact pads to one of the second contact pads. Each of the driver IC contact pads is bonded to a corresponding one of the first contact pads of the flexible PCB. The LED lighting circuit further comprises a circuit board assembly comprising a circuit board on a heat spreader and circuit board assembly contact pads. Each of the circuit board assembly contact pads is bonded to a corresponding one of the second contact pads of the flexible PCB, and a thermal bond is formed between the driver IC of the augmented LED array assembly and the heat spreader of the circuit board assembly.

### BRIEF DESCRIPTION OF THE DRAWINGS

Fig. 1A is a top view of an example LED array;
Fig. 1B shows a cross-section through an embodiment of an augmented LED array assembly;
Fig. 2 shows a cross-section through a contact bridge carrier of an augmented LED array assembly;
Fig. 3 shows a plan view of an embodiment of an augmented LED array assembly;
Fig. 4 shows a plan view of a further embodiment of an augmented LED array assembly;
Fig. 5 shows a cross-section through an embodiment of an LED lighting circuit falling under the claimed invention;
Fig. 6 shows a prior art LED lighting circuit;
Fig. 7 is a diagram of an example vehicle headlamp system; and
Fig. 8 is a diagram of another example vehicle headlamp system.

### DETAILED DESCRIPTION OF THE PREFERRED EMBODIMENTS

Examples of different light illumination systems and/or light emitting diode ("LED") implementations will be described more fully hereinafter with reference to the accompanying drawings. These examples are not mutually exclusive, and features found in one example may be combined with features found in one or more other examples to achieve additional implementations. Accordingly, it will be understood that the examples shown in the accompanying drawings are provided for illustrative purposes only and they are not intended to limit the disclosure in any way. Like numbers refer to like elements throughout.

It will be understood that, although the terms first, second, third, etc. may be used herein to describe various elements, these elements should not be limited by these terms. These terms may be used to distinguish one element from another. For example, a first element may be termed a second element and a second element may be termed a first element without departing from the scope of the present invention. As used herein, the term "and/or" may include any and all combinations of one or more of the associated listed items.

It will be understood that when an element such as a layer, region, or substrate is referred to as being "on" or extending "onto" another element, it may be directly on or extend directly onto the other element or intervening elements may also be present. In contrast, when an element is referred to as being "directly on" or extending "directly onto" another element, there may be no intervening elements present. It will also be understood that when an element is referred to as being "connected" or "coupled" to another element, it may be directly connected or coupled to the other element and/or connected or coupled to the other element via one or more intervening elements. In contrast, when an element is referred to as being "directly connected" or "directly coupled" to another element, there are no intervening elements present between the element and the other element. It will be understood that these terms are intended to encompass different orientations of the element in addition to any orientation depicted in the figures.

Relative terms such as "below," "above," "upper," "lower," "horizontal" or "vertical" may be used herein to describe a relationship of one element, layer, or region to another element, layer, or region as illustrated in the figures. It will be understood that these terms are intended to encompass different orientations of the device in addition to the orientation depicted in the figures.

Further, whether the LEDs, LED arrays, electrical components and/or electronic components are housed on one, two or more electronics boards may also depend on design constraints and/or application.

An LED array may have a low pixel count, for example 10 - 80 single-die LEDs arranged in an array formation. For an LED array with a high pixel count, which may provide for greater resolution, it may be preferred to implement a fully integrated micro-LED device with several thousand LEDs or pixels.

Such a micro-LED device may be provided in an assembly that includes a monolithic micro-LED array on top of a driver integrated circuit (IC) such as a complementary metal oxide semiconductor (CMOS) IC, which may control the individual pixels of the LED array. Such a micro-LED assembly or LED array assembly should be incorporated in the system under consideration of the required electrical and thermal interfaces. The micro-LED assembly may also be connected to other circuitry on a printed circuit board (PCB), which may provide the electrical connections to control circuitry. A heat spreader may also be provided to dissipate heat from the LED array during operation.

Such an LED array assembly may need to first be attached to the heatsink before it can be connected to the PCB. The electrical connections to the PCB may be made using wire bonds. However, such assembly steps may be expensive, and it can be difficult to accurately form a large number of wire bonds in the confined space available. Embodiments described herein, therefore, provide for improved mechanisms for incorporating an LED array assembly into a lighting circuit.

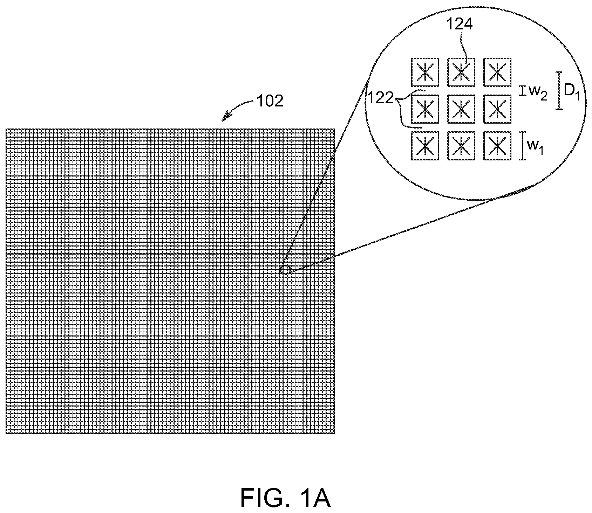

Figure 1A is a top view of an example LED array 102. In the example illustrated in Figure 1A, the LED array 102 is an array of emitters 124. LED arrays may be used for any application, such as those requiring precision control of LED array emitters. Emitters 124 in the LED array 102 may be individually addressable or may be addressable in groups/subsets.

An exploded view of a 3x3 portion of the LED array 102 is also shown in Figure 1A. As shown in the 3x3 portion exploded view, the LED array 102 may include emitters 124 that each have a width w₁. In embodiments, the width w₁ may be approximately 100µm or less (e.g., 40 µm). Lanes 122 between the emitters 124 may be a width, w₂, wide. In embodiments, the width w₂ may be approximately 20µm or less (e.g., 5µm). The lanes 122 may provide an air gap between adjacent emitters or may contain other material. A distance D₁ from the center of one emitter 124 to the center of an adjacent emitter 124 may be approximately 120µm or less (e.g., 45µm). It will be understood that the widths and distances provided herein are examples only and that actual widths and/or dimensions may vary.

It will be understood that, although rectangular emitters arranged in a symmetric matrix are shown in Figure 1A, emitters of any shape and arrangement may be applied to the embodiments described herein. For example, the LED array 102 of Figure 1A may include over 20,000 emitters in any applicable arrangement, such as a 200x100 matrix, a symmetric matrix, a non-symmetric matrix, or the like. It will also be understood that multiple sets of emitters, matrixes, and/or boards may be arranged in any applicable format to implement the embodiments described herein.

As mentioned above, LED arrays, such as the LED array 102, may include up to 20,000 or more emitters. Such arrays may have a surface area of 90 mm² or greater and may require significant power to power them, such as 60 watts or more. An LED array such as this may be referred to as a micro LED array or simply a micro LED. A micro LED may include an array of individual emitters provided on a substrate or may be a single silicon wafer or die divided into segments that form the emitters. The latter type of micro LED may be referred to as a monolithic LED.

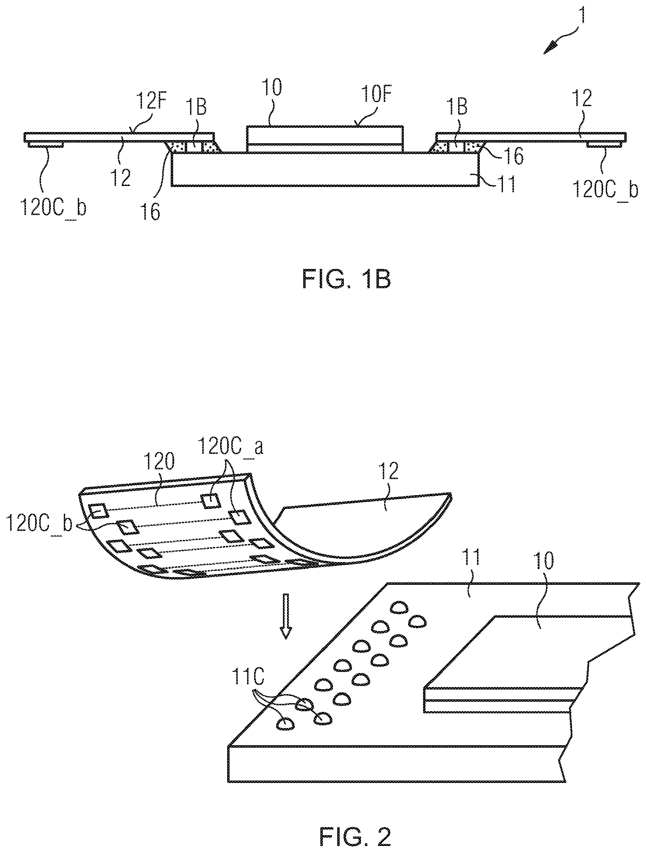

Figure 1B shows an embodiment of an augmented LED array assembly 1, and shows a hybridized device configured for inclusion in an LED lighting circuit. In the example illustrated in Figure 1B, the hybridized device includes a micro-LED array 10, such as the LED array 102 of Figure 1A, mounted onto a driver integrated circuit 11. In one or more embodiments, the micro-LED array may include an array of micrometer-scale LED pixels. In embodiments, the pixel size may be less than 100 µm and may even be in the order of 1 µm. The micro-LED array may be provided as a single die with a two-dimensional array of LEDs or as an array of individual dies. The micro-LED array can be mounted onto the driver IC in a die-on-die assembly using soldering interconnection such as solder bumps, micro bumps, copper pillar bumps, etc. A micro-LED array of such an LED assembly may have a rated power in the order of 60 W.

In embodiments, the driver IC 11 may be realized using CMOS semiconductor manufacturing processes. Such a driver IC may simply be referred to as a CMOS driver IC. In one or more non-limiting embodiments, the driver integrated circuit is a CMOS driver IC. The driver IC 11 may also be referred to as a silicon backplane herein.

In some embodiments, the micro-LED array has been mounted to the driver IC, for example in a reflow-solder procedure. The driver IC may be essentially square or rectangular when viewed from above and may have an arrangement of contact pads near all four edges of its upper face, for example, 50 - 200 contact pads distributed along the edges of the CMOS IC to drive a micro-LED array with 1,000 - 20,000 LEDs. The micro-LED array may be centered on the upper surface of the driver IC.

An augmented LED array assembly, according to one or more embodiments, may be understood to mean that the hybridized device is augmented by a planar contact bridge carrier and that the completed augmented LED array assembly can be handled as a separate component. Thus, in some embodiments, the second contact pads of the contact bridge carrier may essentially be electrical connections to the driver IC contact pads. In a subsequent manufacturing stage, the augmented LED array assembly may be easily mounted in a lighting circuit since there will not be any need to form wire bonds to the driver IC contact pads.

In some embodiments, an augmented LED array assembly may enable the planar contact bridge carrier to be used to assist in handling the assembly. For example, a tool, such as a pick-and-place machine, can apply suction against the upper surface of the contact bridge carrier to hold the assembly when moving it from one location to another. Such ease of handling may ensure that damage to the assembly, such as the emission face of the LED array, can be avoided. This may be in contrast to conventional assemblies, in which an LED assembly may not include the contacts that may later be needed to connect to a PCB, and for which these contacts must later be made using wire bonds after the LED assembly is mounted onto the heatsink. Augmented LED array assemblies, such as described herein, however, may already include the contacts in the form of the contact bridge carrier such that the process of connecting the augmented LED array assembly to a PCB may be greatly simplified.

In embodiments, the augmented LED array assembly may include a number of passive circuit components, such as capacitors and resistors, mounted on the contact bridge carrier.

Figure 2 illustrates a manufacturing stage of the augmented LED array assembly 1, and shows a flexible contact bridge carrier 12 relative to one side of the driver IC 11. The driver IC 11 includes contact pads 11C, such as gold bumps of a ball grid array (BGA), which may serve to electrically connect the driver IC 11 to external circuitry.

In some embodiments, the flexible contact bridge carrier 12 may be an essentially planar flexible carrier with a number of contact bridges 120. In some embodiments, the flexible contact bridge carrier 12 may be a thin flexible PCB with contact bridges 120 in its interior. A contact bridge 120 extends between a first contact pad 120C_a and a second contact pad 120C_b. The contact pads 120C_a, 120C_b can be made by depositing or printing copper or any other suitable metal.

In embodiments, the flexible contact bridge carrier 12 may be a single-layer carrier where the contact bridges are printed or deposited as conductive tracks on one face of the carrier, such as its lower face. In embodiments, the contact bridge carrier can include a multi-layer substrate with the contact bridges formed in an interior layer of the carrier. The outer layers of the flexible PCB may be a suitable material, such as polyimide. In some embodiments, the contact bridge carrier may be flexible with thin conductive tracks enclosed in layers of a material, such as polyimide.

Each contact pad 11C of the driver IC 11 is soldered or bonded to a first contact pad 120C_a of the flexible contact bridge carrier 12 to achieve a permanent bond (or: solder bond) 1B, as shown in Figure 1B, which also indicates an underfill 16 applied to the solder bond 1B in order to prevent damage to the electrical connection during handling of the augmented LED array assembly 1. In the example illustrated in Figure 1B, the upper face 12F of the flexible contact bridge carrier 12 is no higher than the emission face 10F of the micro-LED array 10. The underfill 16 may be used, for example, because the planar carrier may be very thin and have an inherent degree of flexibility. In such embodiments, the underfill 16 may protect the solder bonds at the first contact pads of the contact bridge carrier. The underfill 16 may completely surround a solder bond or may be applied along one or more sides of a solder bond, for example.

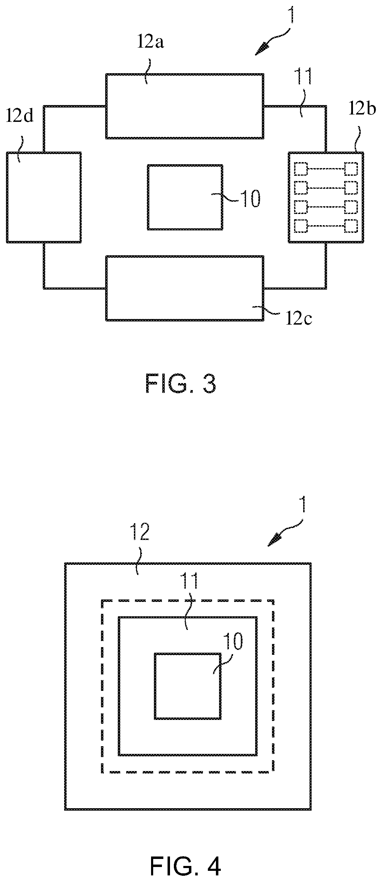

Figure 3 shows a plan view of an embodiment of an augmented LED array assembly 1. In the example illustrated in Figure 3, the flexible contact bridge carrier 12 has four carrier sections 12a, 12b, 12c and 12d arranged along the four sides of the augmented LED array assembly 1. Each carrier section 12a, 12b, 12c and 12d can connect one quarter of the driver contacts to a circuit board assembly. A number of contact pads 120C_a, 120C_b and contact bridges 120 are indicated by the broken lines on the right-hand side carrier section 12b.

In embodiments, the number of sections may be more than four or less than four (e.g., two L-shaped contact bridge carriers or up to four sections). Each section may extend outwards in the direction of the PCB to which the LED assembly will be connected.

Figure 4 shows a plan view of a further embodiment of an augmented LED array assembly 1. In the example illustrated in Figure 4, the planar carrier has the form of a square collar and extends about the four sides of the augmented LED array assembly 1. The outer perimeter of the driver IC 11 is indicated by the dotted line.

In embodiments, the square collar may include a square aperture for the light-emitting surface of the micro-LED array and may have first contact pads along all four inner edges and second contact pads along all four outer edges.

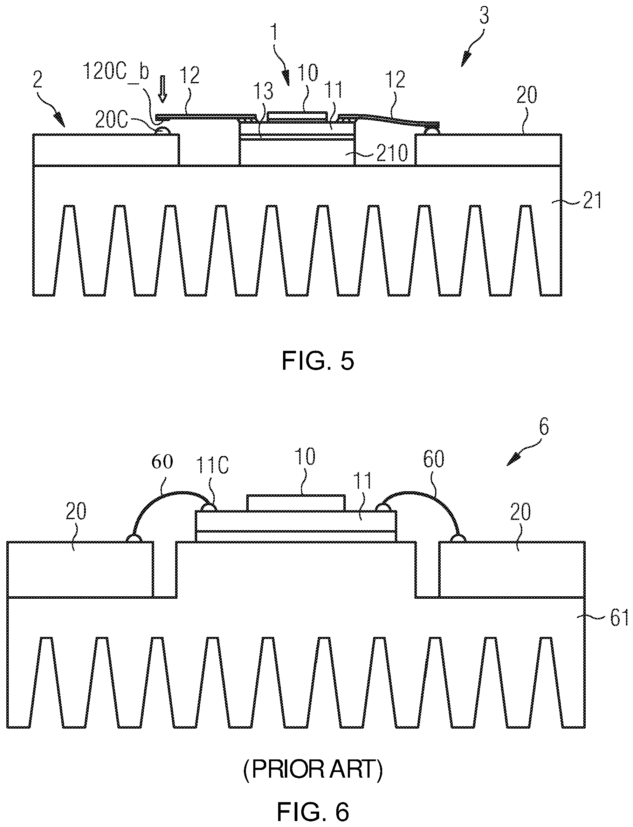

Figure 5 shows an embodiment of an LED lighting circuit 3 falling under the claimed invention at a manufacturing stage. In the example illustrated in Figure 5, the LED lighting circuit 3 includes a circuit board assembly 2 with a circuit board 20 mounted onto a heat spreader 21. The circuit board 20 has contact pads 20C configured for electrical connections to the driver IC 11 of the augmented LED array assembly 1.

In some embodiments, the circuit board 20 may be a PCB that is formed to receive an LED assembly. Such a PCB may be formed to have a cut-out that is large enough to receive the LED assembly.

Figure 5 shows an embodiment of the augmented LED array assembly 1 after forming a thermal bond 13 between the driver IC 11 and the heat spreader 21 of the circuit board assembly 2. In this embodiment, the heat spreader 21 is shaped to have a raised seat 210 configured to receive the driver IC 11. On the left-hand side of the diagram, the second contact pad 120C_b of the flexible contact bridge carrier 12 is about to be soldered to a corresponding contact pad 20C of the circuit board 20. To this end, a hot bar soldering tool may press the flexible contact bridge carrier 12 towards the circuit board 20. while applying heat. The combination of heat and pressure bonds the second contact pad 120C_b to the circuit board contact pad 20C. On the right-hand side of the diagram, the second contact pad 120C_b of the flexible contact bridge carrier 12 has already been soldered to a corresponding contact pad 20C of the circuit board 20. The flexibility of the flexible contact bridge carrier 12 may make it easy to form the bonds and may also allow a considerable difference in height to be overcome.

In some embodiments, the LED lighting circuit may make it simple to make the electrical connections between contact pads of the PCB and the second contact pads of the contact bridge carrier. It may also be relatively easy to design the contact bridge carrier so that, when the augmented LED array assembly is put into place, the set of second contact pads of the contact bridge carrier are aligned with high precision over the PCB contact pads. A precise alignment may ensure that solder connections can be easily and accurately made.

In some embodiments, the circuit board 20 may include an aperture exposing a region of the heat spreader 21, and the aperture may be shaped to accommodate the LED array assembly. The clearance can serve to improve heat dissipation during operation. In embodiments, the raised seat 210 may extend upward into the aperture.

Figure 6 shows an LED lighting circuit 6 with a driver IC 11 mounted on a heat sink 61 arranged in an aperture of a circuit board 20. In the example illustrated in Figure 6, wire bonds 60 are used to connect the contact pads 20C of the circuit board 20 to contact pads 11C of the driver IC 11. This type of assembly can be expensive when the driver IC 11 has many contact pads 11C, for example 200 contact pads 11C, requiring 200 wire bonds 60.

The contact bridge carrier described herein may provide an improvement over the conventional approach of using wire bonds to connect an LED assembly to a PCB. However, the contact bridge carrier may not be restricted to providing bridges between PCB contacts and driver IC contacts. In some embodiments, the contact bridge carrier may also include conductive tracks for additional switching circuitry. Such tracks can be embedded in the body of the carrier, with contact pads at the upper or lower surface of the carrier, as appropriate. One or more embodiments of an augmented LED assembly can also include a number of switching circuit components mounted onto the contact bridge carrier. In this way, part of the control circuitry that would otherwise be provided on the PCB can instead be provided on the contact bridge carrier. With such an embodiment, the PCB of the lighting circuit can be smaller than the PCB of a comparable conventional lighting circuit. Furthermore, because the switching circuit components can be closer to the CMOS IC, this can reduce signal noise.

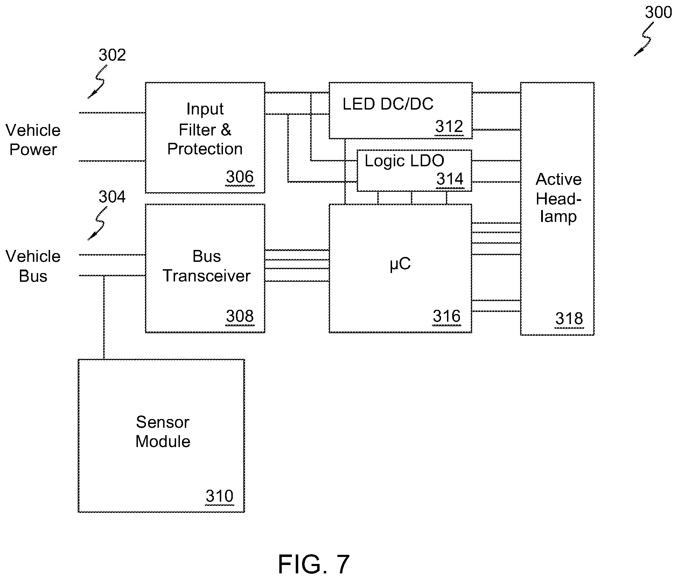

Figure 7 is a diagram of an example vehicle headlamp system 300 that may incorporate the augmented LED array assembly 1. The example vehicle headlamp system 300 illustrated in Figure 7 includes power lines 302, a data bus 304, an input filter and protection module 306, a bus transceiver 308, a sensor module 310, an LED direct current to direct current (DC/DC) module 312, a logic low-dropout (LDO) module 314, a micro-controller 316 and an active head lamp 318. In embodiments, the active head lamp 318 may include an augmented LED array assembly 1, such as described herein.

The power lines 302 may have inputs that receive power from a vehicle, and the data bus 304 may have inputs/outputs over which data may be exchanged between the vehicle and the vehicle headlamp system 300. For example, the vehicle headlamp system 300 may receive instructions from other locations in the vehicle, such as instructions to turn on turn signaling or turn on headlamps, and may send feedback to other locations in the vehicle if desired. The sensor module 310 may be communicatively coupled to the data bus 304 and may provide additional data to the vehicle headlamp system 300 or other locations in the vehicle related to, for example, environmental conditions (e.g., time of day, rain, fog, or ambient light levels), vehicle state (e.g., parked, in-motion, speed of motion, or direction of motion), and presence/position of other objects (e.g., vehicles or pedestrians). A headlamp controller that is separate from any vehicle controller communicatively coupled to the vehicle data bus may also be included in the vehicle headlamp system 300. In Figure 7, the headlamp controller may be a micro-controller, such as micro-controller (µc) 316. The micro-controller 316 may be communicatively coupled to the data bus 304.

The input filter and protection module 306 may be electrically coupled to the power lines 302 and may, for example, support various filters to reduce conducted emissions and provide power immunity. Additionally, the input filter and protection module 306 may provide electrostatic discharge (ESD) protection, load-dump protection, alternator field decay protection, and/or reverse polarity protection.

The LED DC/DC module 312 may be coupled between the input filter and protection module 306 and the active headlamp 318 to receive filtered power and provide a drive current to power LEDs in the LED array in the active headlamp 318. The LED DC/DC module 312 may have an input voltage between 7 and 18 volts with a nominal voltage of approximately 13.2 volts and an output voltage that may be slightly higher (e.g., 0.3 volts) than a maximum voltage for the LED array (e.g., as determined by factor or local calibration and operating condition adjustments due to load, temperature or other factors).

The logic LDO module 314 may be coupled to the input filter and protection module 306 to receive the filtered power. The logic LDO module 314 may also be coupled to the micro-controller 316 and the active headlamp 318 to provide power to the micro-controller 316 and/or the silicon backplane (e.g., CMOS logic) in the active headlamp 318.

The bus transceiver 308 may have, for example, a universal asynchronous receiver transmitter (UART) or serial peripheral interface (SPI) interface and may be coupled to the micro-controller 316. The micro-controller 316 may translate vehicle input based on, or including, data from the sensor module 310. The translated vehicle input may include a video signal that is transferrable to an image buffer in the active headlamp 318. In addition, the micro-controller 316 may load default image frames and test for open/short pixels during startup. In embodiments, an SPI interface may load an image buffer in CMOS. Image frames may be full frame, differential or partial frames. Other features of micro-controller 316 may include control interface monitoring of CMOS status, including die temperature, as well as logic LDO output. In embodiments, LED DC/DC output may be dynamically controlled to minimize headroom. In addition to providing image frame data, other headlamp functions, such as complementary use in conjunction with side marker or turn signal lights, and/or activation of daytime running lights, may also be controlled.

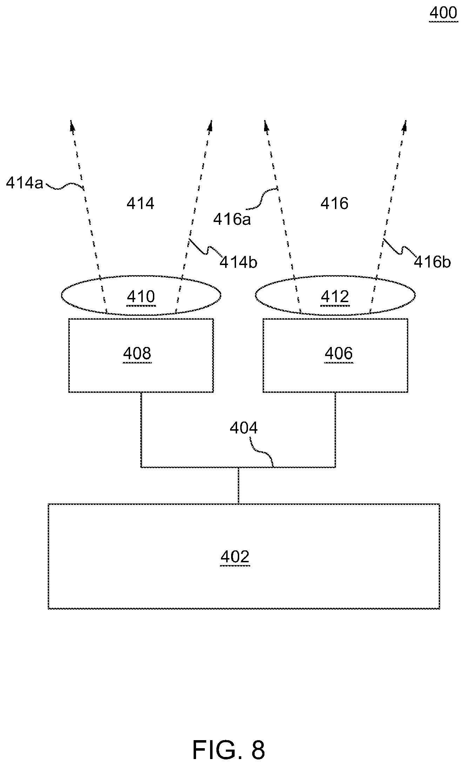

Figure 8 is a diagram of another example vehicle headlamp system 400. The example vehicle headlamp system 400 illustrated in Figure 8 includes an application platform 402, two LED lighting systems 406 and 408, and secondary optics 410 and 412. The two LED lighting systems 406 and 408 may be augmented LED array assemblies, such as the augmented LED array assembly 1, or may include the augmented LED array assembly 1 plus some of all of the other modules in the vehicle headlamp system 300 of Figure 7. In the latter embodiment, the LED lighting systems 406 and 408 may be vehicle headlamp sub-systems.

The second LED lighting system 408 may emit second light beams 414 (shown between arrows 414a and 414b in Fig. 8). The first LED lighting system 406 may emit first light beams 416 (shown between arrows 416a and 416b in Fig. 8). In the embodiment shown in Figure 8, a second, secondary optic 410 is adjacent the second LED lighting system 408, and the light emitted from the second LED lighting system 408 passes through the second, secondary optic 410. Similarly, a first, secondary optic 412 is adjacent the first LED lighting system 406, and the light emitted from the first LED lighting system 406 passes through the first, secondary optic 412. In alternative embodiments, no secondary optics 410, 412 are provided in the vehicle headlamp system.

Where included, the secondary optics 410, 412 may be or include one or more light guides. The one or more light guides may be edge lit or may have an interior opening that defines an interior edge of the light guide. LED lighting systems 408 and 406 (or the active headlamp of a vehicle headlamp sub-system) may be inserted in the interior openings of the one or more light guides such that they inject light into the interior edge (interior opening light guide) or exterior edge (edge lit light guide) of the one or more light guides. In embodiments, the one or more light guides may shape the light emitted by the LED lighting systems 408 and 406 in a desired manner, such as, for example, with a gradient, a chamfered distribution, a narrow distribution, a wide distribution, or an angular distribution.

The application platform 402 may provide power and/or data to the LED lighting systems 406 and/or 408 via lines 404, which may include one or more or a portion of the power lines 302 and the data bus 304 of Figure 7. One or more sensors (which may be the sensors in the vehicle headlamp system 300 or other additional sensors) may be internal or external to the housing of the application platform 402. Alternatively, or in addition, as shown in the example vehicle headlamp system 300 of Figure 7, each LED lighting system 408 and 406 may include its own sensor module, connectivity and control module, power module, and/or LED array.

In embodiments, the vehicle headlamp system 400 may represent an automobile with steerable light beams where LEDs may be selectively activated to provide steerable light. For example, an array of LEDs (e.g., the LED array 102) may be used to define or project a shape or pattern or illuminate only selected sections of a roadway. In an example embodiment, infrared cameras or detector pixels within LED lighting systems 406 and 408 may be sensors (e.g., similar to sensors in the sensor module 310 of Figure 7) that identify portions of a scene (e.g., roadway or pedestrian crossing) that require illumination.

According to an example method of manufacturing an augmented LED array assembly, the method includes providing a hybridized device. The hybridized device includes a micro-LED array mounted onto a driver integrated circuit. The driver integrated circuit includes a number of driver integrated circuit contact pads on a top surface of the driver integrated circuit.

The method also includes providing a flexible PCB. The flexible PCB has a bottom surface, a number of first contact pads on the bottom surface, a number of second contact pads on the bottom surface, and a number of contact bridges. Each of the contact bridges extends between one of the first contact pads and one of the second contact pads.

The method also includes mounting the flexible PCB to the hybridized device. This is done by forming solder bonds between the first contact pads of the flexible PCB and the driver integrated circuit contact pads.

According to an example method of manufacturing an LED lighting circuit, the method includes providing an augmented LED array assembly. The augmented LED array assembly includes an LED array assembly and a flexible PCB. The LED array assembly includes a micro-LED array mounted on a driver IC. The driver IC includes driver IC contact pads on a top surface of the driver IC. The augmented LED array assembly also includes a flexible PCB that has a bottom surface, a number of first contact pads on the bottom surface, a number of second contact pads on the bottom surface, and a number of contact bridges. Each of the contact bridges extends from one of the first contact pads to one of the second contact pads. Each of the driver IC contact pads is bonded to a corresponding one of the first contact pads of the flexible PCB.

The method also includes providing a circuit board assembly. The circuit board assembly includes a circuit board mounted onto a heat spreader and circuit board assembly contact pads.

The method also includes mounting the augmented LED array assembly to the heat spreader. This may be done, for example, by first applying a thermally-conductive adhesive layer to a dedicated mounting surface of the heat spreader. This mounting surface can be a region of the heat spreader exposed by an aperture in the PCB. The thermally-conductive adhesive layer may be any of a layer of thermally conductive glue, a thermal paste, a silver thermal compound, a double-sided adhesive tape, etc. In embodiments, a heat-curable thermal adhesive may be used. In this case, the mounting the augmented LED array assembly to the heat spreader may be followed by oven-curing the thermally-conductive adhesive layer.

The method also includes bonding the second contact pads of the flexible PCB to the circuit board. This may be done, for example, by hot bar soldering. To this end, one or both sets of contact pads may be coated with a solder filler metal. Assuming the contact pads of each pair are in alignment, they can be permanently bonded together by simply applying pressure and heat. This can be done by pressing the heated tip of a tool (e.g., hot bar) onto the upper face of the contact bridge carrier.

In some embodiments, the flexible contact bridge carrier may be used to accommodate a height difference of, for example, several millimeters between its outer perimeter and the upper face of the PCB. With a sufficiently flexible contact bridge carrier, the outer perimeter may be deflected downwards during a bonding step, such as described above.

Having described the embodiments in detail, those skilled in the art will appreciate that, given the present description, modifications may be made to the embodiments described herein without departing from the scope of the invention. Therefore, it is not intended that the scope of the invention be limited to the specific embodiments illustrated and described. The scope of the present invention is defined by the appended claims.

## Claims

1. A method of manufacturing a light emitting diode, LED, lighting circuit (3), comprising:
providing an augmented LED array assembly (1) by: providing an LED array assembly, the LED array assembly comprising a micro-LED array (10) mounted onto a driver integrated circuit (11), the driver integrated circuit (11) comprising a plurality of driver integrated circuit contact pads(11C) on a top surface of the driver integrated circuit (11); providing a flexible printed circuit board, PCB, comprising a bottom surface, a plurality of first contact pads (120C_a) on the bottom surface, a plurality of second contact pads (120C_b) on the bottom surface, and a plurality of contact bridges (120), each of the plurality of contact bridges (120) extending between one of the plurality of first contact pads (120C_a) and one of the plurality of second contact pads (120C_b); and
mounting the flexible PCB to the LED array assembly by forming solder bonds (1B) between the plurality of first contact pads (120C_a) of the flexible PCB and the driver integrated circuit contact pads (11C),
**characterised in that** the method further comprises:
providing a circuit board assembly (2) comprising a circuit board (20) mounted onto a heat spreader (21) and comprising circuit board assembly contact pads;
mounting the augmented LED array assembly (1) to the heat spreader (21); and
bonding the plurality of second contact pads (120C_b) of the flexible PCB to the circuit board assembly contact pads.

2. The method according to claim 1, wherein the solder bonds (1B) are formed in a reflow soldering process.

3. The method according to claim 1, wherein the solder bonds (1B) are formed in a diffusion soldering process.

4. The method according to claim 1, wherein mounting the augmented LED array assembly (1) to the heat spreader (21) is preceded by applying a thermally-conductive adhesive layer to a mounting surface of the heat spreader (21).

5. The method according to claim 4, wherein the mounting the augmented LED array assembly (1) to the heat spreader (21) is followed by curing the thermally-conductive adhesive layer

6. The method according to claim 1, wherein bonding the second contact pads (120C_b) of the flexible PCB to the circuit board assembly contact pads is performed by hot bar soldering.

7. An LED lighting circuit (3) comprising:
an augmented LED array assembly (1) comprising:
an LED array assembly comprising a micro-LED array (10) mounted on a driver integrated circuit, IC, (11), the driver integrated circuit (11) comprising a plurality of driver IC contact pads (11C) on a top surface of the driver IC (11); and
a flexible printed circuit board, PCB, the flexible PCB comprising a bottom surface, a plurality of first contact pads (120C_a) on the bottom surface, a plurality of second contact pads (120C_b) on the bottom surface, and a plurality of contact bridges (120), each of the plurality of contact bridges (120) extending from one of the plurality of first contact pads (120C_a) to one of the plurality of second contact pads (120C_b), and
each of the plurality of driver IC contact pads (11C) being bonded to a corresponding one of the plurality of first contact pads (120C_a) of the flexible PCB,
**characterised in that** the LED lighting circuit (3) further comprises a circuit board assembly (2) comprising a circuit board (20) on a heat spreader (21) and circuit board assembly contact pads, wherein: each of the circuit board assembly contact pads is bonded to a corresponding one of the plurality of second contact pads (120C_b) of the flexible PCB, and a thermal bond (13) is formed between the driver integrated circuit (11) of the augmented LED array assembly (1) and the heat spreader (21) of the circuit board assembly (2).

8. The LED lighting circuit (3) according to claim 7, wherein the flexible PCB comprises a multi-layer flexible substrate.

9. The LED lighting circuit (3) according to claim 7, wherein:
the micro-LED array (10) has an emission face (10F), and
an upper face of the flexible PCB is not higher than the emission face(10F) of the micro-LED array (10).

10. The LED lighting circuit (3) according to claim 7, further comprising a plurality of passive circuit components on the flexible PCB.

11. The LED lighting circuit (3) according to claim 7, wherein the flexible PCB further comprises conductive tracks for additional switching circuitry.

12. The LED lighting circuit (3) according to claim 11, further comprising a plurality of switching circuit components on the flexible PCB.

13. The LED lighting circuit (3) according to claim 7, wherein:
the circuit board (20) includes an aperture, and
the heat spreader (21) comprises a raised seat (210) extending upward into the aperture and configured to receive the driver IC (11) of the augmented LED array assembly (1).

## Patentansprüche

1. Verfahren zur Herstellung einer Leuchtdioden-, LED, Beleuchtungsschaltung (3), umfassend:
Bereitstellen einer erweiterten LED-Array-Baugruppe (1) durch:
Bereitstellen einer LED-Array-Baugruppe, wobei die LED-Array-Baugruppe ein Mikro-LED-Array (10) aufweist, das auf einer integrierten Treiberschaltung (11) montiert ist, wobei die integrierte Treiberschaltung (11) eine Vielzahl von Kontaktpads (11C) der integrierten Treiberschaltung auf einer Oberseite der integrierten Treiberschaltung (11) aufweist;
Bereitstellen einer flexiblen Leiterplatte, PCB, die eine Unterseite, eine Vielzahl von ersten Kontaktpads (120C_a) auf der Unterseite, eine Vielzahl von zweiten Kontaktpads (120C_b) auf der Unterseite und eine Vielzahl von Kontaktbrücken (120) aufweist, wobei sich jede der Vielzahl von Kontaktbrücken (120) zwischen einem der Vielzahl von ersten Kontaktpads (120C_a) und einer der Vielzahl von zweiten Kontaktpads (120C_b) erstreckt; und
Montieren der flexiblen PCB an der LED-Array-Baugruppe durch Bilden von Lötverbindungen (1B) zwischen der Vielzahl von ersten Kontaktpads (120C_a) der flexiblen PCB und den Kontaktpads (11C) der integrierten Treiberschaltung,
**dadurch gekennzeichnet, dass** das Verfahren ferner umfasst:
Bereitstellen einer Leiterplattenbaugruppe (2), die eine auf einem Wärmeverteiler (21) montierte Leiterplatte (20) aufweist und Kontaktpads der Leiterplattenbaugruppe aufweist;
Montieren der erweiterten LED-Array-Baugruppe (1) am Wärmeverteiler (21); und
Bonden der Vielzahl von zweiten Kontaktpads (120C_b) der flexiblen PCB mit den Kontaktpads der Leiterplattenbaugruppe.

2. Verfahren nach Anspruch 1, wobei die Lötverbindungen (1B) in einem Reflow-Lötverfahren gebildet werden.

3. Verfahren nach Anspruch 1, wobei die Lötverbindungen (1B) in einem Diffusionslötverfahren gebildet werden.

4. Verfahren nach Anspruch 1, wobei vor dem Montieren der erweiterten LED-Array-Baugruppe (1) am Wärmeverteiler (21) eine wärmeleitende Klebstoffschicht auf eine Montagefläche des Wärmeverteilers (21) aufgebracht wird.

5. Verfahren nach Anspruch 4, wobei auf das Montieren der erweiterten LED-Array-Baugruppe (1) am Wärmeverteiler (21) das Aushärten der wärmeleitenden Klebstoffschicht folgt.

6. Verfahren nach Anspruch 1, wobei das Bonden der Vielzahl von zweiten Kontaktpads (120C_b) der flexiblen PCB mit den Kontaktpads der Leiterplattenbaugruppe durch Bügellöten erfolgt.

7. LED-Beleuchtungsschaltung (3), die aufweist:
eine erweiterte LED-Array-Baugruppe (1), die aufweist:
eine LED-Array-Baugruppe, die ein Mikro-LED-Array (10) aufweist, das auf einer integrierten Treiberschaltung, IC, (11) montiert ist, wobei die integrierte Treiberschaltung (11) eine Vielzahl von Kontaktpads (11C) der Treiber-IC auf einer Oberseite der Treiber-IC (11) aufweist; und
eine flexible Leiterplatte, PCB, wobei die flexible PCB eine Unterseite, eine Vielzahl von ersten Kontaktpads (120C_a) auf der Unterseite, eine Vielzahl von zweiten Kontaktpads (120C_b) auf der Unterseite und eine Vielzahl von Kontaktbrücken (120) aufweist, wobei sich jede der Vielzahl von Kontaktbrücken (120) von einem der Vielzahl von ersten Kontaktpads (120C_a) zu einem der Vielzahl von zweiten Kontaktpads (120C_b) erstreckt, und
wobei jeder der Vielzahl von Kontaktpads (11C) der Treiber-IC mit einem entsprechenden der Vielzahl von ersten Kontaktpads (120C_a) der flexiblen PCB verbondet ist,
**dadurch gekennzeichnet, dass** die LED-Beleuchtungsschaltung (3) ferner eine Leiterplattenbaugruppe (2) aufweist, die eine Leiterplatte (20) auf einem Wärmeverteiler (21) und Kontaktpads der Leiterplattenbaugruppe aufweist, wobei:
jeder der Kontaktpads (20C) der Leiterplattenbaugruppe mit einem entsprechenden der Vielzahl von zweiten Kontaktpads (120C_b) der flexiblen PCB verbondet ist, und
eine thermische Verbindung (13) zwischen der integrierten Treiberschaltung (11) der erweiterten LED-Array-Baugruppe (1) und dem Wärmeverteiler (21) der Leiterplattenbaugruppe (2) ausgebildet ist.

8. LED-Beleuchtungsschaltung (3) nach Anspruch 7, wobei die flexible PCB ein mehrschichtiges flexibles Substrat aufweist.

9. LED-Beleuchtungsschaltung (3) nach Anspruch 7, wobei:
das Mikro-LED-Array (10) eine Emissionsfläche (10F) aufweist, und
eine Oberseite der flexiblen PCB nicht höher als die Emissionsfläche (10F) des Mikro-LED-Arrays (10) ist.

10. LED-Beleuchtungsschaltung (3) nach Anspruch 7, die ferner eine Vielzahl von passiven Schaltungskomponenten auf der flexiblen PCB aufweist.

11. LED-Beleuchtungsschaltung (3) nach Anspruch 7, wobei die flexible PCB ferner Leiterbahnen für zusätzliche Schaltkreise aufweist.

12. LED-Beleuchtungsschaltung (3) nach Anspruch 11, die ferner eine Vielzahl von Schaltkreiskomponenten auf der flexiblen PCB aufweist.

13. LED-Beleuchtungsschaltung (3) nach Anspruch 7, wobei:
die Leiterplatte (20) eine Apertur aufweist, und
der Wärmeverteiler (21) einen erhöhten Sitz (210) aufweist, der sich nach oben in die Apertur hinein erstreckt und so ausgebildet ist, dass er die Treiber-IC (11) der erweiterten LED-Array-Baugruppe (1) aufnimmt.

## Revendications

1. Procédé de fabrication d'un circuit d'éclairage à diodes électroluminescentes, dites DEL, (3), comprenant les étapes consistant à :
obtenir un ensemble réseau de DEL augmenté (1) par :
une utilisation d'un ensemble réseau de DEL, l'ensemble réseau de DEL comprenant un réseau de micro-DEL (10) monté sur un circuit intégré de pilotage (11), le circuit intégré de pilotage (11) comprenant une pluralité de pastilles de contact de circuit intégré de pilotage (11C) sur une surface supérieure du circuit intégré de pilotage (11) ;
utiliser une carte à circuits imprimés, dite PCB, flexible comprenant une surface inférieure, une pluralité de première pastilles de contact (120C_a) sur la surface inférieure, une pluralité de secondes pastilles de contact (120C_b) sur la surface inférieure, et une pluralité de ponts de contact (120), chaque pont de la pluralité de ponts de contact (120) s'étendant entre une pastille de la pluralité de premières pastilles de contact (120C_a) et une pastille de la pluralité de secondes pastilles de contact (120C_b) ; et
monter la PCB flexible sur l'ensemble réseau de DEL en formant des soudures (1B) entre les pastilles de la pluralité de premières pastilles de contact (120C_a) de la PCB flexible et les pastilles de contact de circuit intégré de pilotage (11C),
**caractérisé en ce que** le procédé comprend en outre les étapes consistant à :
utiliser un ensemble de carte imprimée (2) comprenant une carte imprimée (20) montée sur un dissipateur thermique (21) et comprenant des pastilles de contact d'ensemble de carte imprimée ;
monter l'ensemble réseau de DEL augmenté (1) sur le dissipateur thermique (21) ; et
lier les pastilles de la pluralité de pastilles de contact (120C_b) de la PCB flexible et les pastilles de contact de l'ensemble de carte imprimée.

2. Procédé selon la revendication 1, dans lequel les soudures (1B) sont formées lors d'un traitement de soudage par refusion.

3. Procédé selon la revendication 1, dans lequel les soudures (1B) sont formées lors d'un traitement de brasage tendre par diffusion.

4. Procédé selon la revendication 1, dans lequel l'étape de montage de l'ensemble réseau de DEL augmenté (1) sur le dissipateur thermique (21) est précédée par une application d'une couche d'adhésif thermoconducteur sur une surface de montage du dissipateur thermique (21).

5. Procédé selon la revendication 4, dans lequel l'étape de montage de l'ensemble réseau de DEL augmenté (1) sur le dissipateur thermique (21) est suivie par un durcissement de la couche d'adhésif thermoconducteur.

6. Procédé selon la revendication 1, dans lequel l'étape de liaison des secondes pastilles de contact (120C_b) de la PCB flexible aux pastilles de contact de l'ensemble de carte imprimée est effectuée par un brasage en barre chauffante.

7. Circuit d'éclairage à DEL (3), comprenant
un ensemble réseau de DEL augmenté (1), comprenant :
un ensemble réseau de DEL comprenant un réseau de micro-DEL (10) monté sur un circuit intégré, dit CI, de pilotage (11), le circuit intégré de pilotage (11) comprenant une pluralité de pastilles de contact de CI de pilotage (11C) sur une surface supérieure du CI de pilotage (11) ; et
une carte à circuits imprimés, dite PCB, flexible, la PCB flexible comprenant une surface inférieure, une pluralité de premières pastilles de contact (120C_a) sur la surface inférieure, une pluralité de secondes pastilles de contact (120C_b) sur la surface inférieure et une pluralité de ponts de contact (120), chaque pont de la pluralité de ponts de contact (120) s'étendant d'une pastille de la pluralité de premières pastilles de contact (120C_a) à une pastilles de la pluralité de secondes pastilles de contact (120C_b), et
chaque pastille de la pluralité de pastilles de CI de pilotage (11C) étant liée à une pastille correspondante de la pluralité de premières pastilles de contact (120C_a) de la PCB flexible,
**caractérisé en ce que** le circuit d'éclairage à DEL (3) comprend en outre un ensemble de carte imprimée (2) comprenant une carte imprimée (20) sur un dissipateur thermique (21) et des pastilles de contact d'ensemble de carte imprimée,
dans lequel :
chaque pastille de la pluralité de pastilles de contact d'ensemble de carte imprimée est liée à une pastille correspondante de la pluralité de secondes pastilles de contact (120C_b) de la PCB flexible, et une liaison thermique (13) est formée entre le circuit intégré de pilotage (11) de l'ensemble réseau de DEL augmenté (1) et le dissipateur thermique (21) de l'ensemble de carte imprimée (2).

8. Circuit d'éclairage à DEL (3) selon la revendication 7, dans lequel la PCB flexible comprend un substrat flexible multicouche.

9. Circuit d'éclairage à DEL (3) selon la revendication 7, dans lequel :
le réseau de micro-DEL (10) comporte une face d'émission (10F), et
une face supérieure de la PCB flexible n'est pas située plus haute que la face d'émission (10F) du réseau de micro-DEL (10).

10. Circuit d'éclairage à DEL (3) selon la revendication 7, comprenant en outre une pluralité de composants de circuit passifs sur la PCB flexible.

11. Circuit d'éclairage à DEL (3) selon la revendication 7, dans lequel la PCB flexible comprend en outre des pistes conductrices destinées à des circuits de commutation supplémentaires.

12. Circuit d'éclairage à DEL (3) selon la revendication 11, comprend en outre une pluralité de composants de circuit de commutation sur la PCB flexible.

13. Circuit d'éclairage à DEL (3) selon la revendication 7, dans lequel :
la carte imprimée (20) possède une ouverture, et
le dissipateur thermique (21) comprend un siège surélevé (210) s'étendant vers le haut dans l'ouverture et configuré pour recevoir le CI de pilotage (11) de l'ensemble réseau de DEL augmenté (1).
